(19) **Europäisches Patentamt / European Patent Office / Office européen des brevets**

(11) **EP 1 770 657 B1**

(12) **EUROPEAN PATENT SPECIFICATION**

(45) Date of publication and mention
of the grant of the patent:
**24.10.2012 Bulletin 2012/43**

(51) Int Cl.:
*G07D 7/04* *(2006.01)*     *G01R 33/12* *(2006.01)*

(21) Application number: **06121453.2**

(22) Date of filing: **28.09.2006**

(54) **Method and apparatus for detecting a magnetic feature on an article**

Verfahren und Vorrichtung zur Erkennung eines magnetischen Merkmals an einem Artikel

Procédé et appareil de détection d'une caractéristique magnétique sur un article

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.09.2005 GB 0519971**

(43) Date of publication of application:
**04.04.2007 Bulletin 2007/14**

(73) Proprietor: **De La Rue International Limited
Basingstoke, Hampshire RG22 4BS (GB)**

(72) Inventors:
• **Snelling, James Peter
Andover, SP11 6DF (GB)**

• **Buttifant, John
Ferring, West Sussex BN12 6QR (GB)**

(74) Representative: **Skone James, Robert Edmund
Gill Jennings & Every LLP
The Broadgate Tower
20 Primrose Street
London EC2A 2ES (GB)**

(56) References cited:
**EP-A1- 0 640 841     FR-A- 2 561 427
GB-A- 1 534 859     US-B1- 6 230 972
US-B1- 6 707 295     US-B1- 6 778 358**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a method and apparatus for detecting a magnetic feature on an article. The invention is concerned, for example, with detecting magnetic features on documents of value such as banknotes.

Conventionally, banknotes and other documents of value carry magnetic features, typically in the form of security threads and magnetic print, which allow the genuineness of a banknote to be tested automatically.

US-A-4584529 describes a relatively simple apparatus for detecting magnetic features, for example in magnetic ink, on a banknote. The banknote is fed past a magnetic head which samples at regular intervals and the magnitude of the magnetic field in each sample is detected. The detection signal is converted into pulse signals which are counted and if the pulse count reaches a satisfactory value in relation to a particular, predetermined portion of the banknote, then the banknote is passed as genuine.

US-A-4749087 describes another example of apparatus for detecting magnetic ink. In this case, the processing is a little more complex than that described in US-A-4584529 but the basis is similar in that the magnitude of the magnetic field within a certain window is determined and then compared with a predetermined range.

US-A-6707295 describes a more sophisticated detection system which aims to distinguish between different magnetic materials and in particular between semi-soft magnetic materials on the one hand and soft magnetic materials on the other. It achieves this using the relative time or phase delays in a magnetic signal white also detecting the width of the signal peaks.

GB-A-1534859 and GB-A-2130414 describe apparatus for detecting the magnetic coercivity of a magnetic material on a document by subjecting the material to successive magnetic fields having different polarities and determining the extent to which the magnetic material is influenced by the magnetic fields. This apparatus is relatively complex.

EP-A-640841 discloses another system for detecting magnetic properties of banknotes, wherein the saturation magnetisation and the non-saturation magnetisation of the banknotes are sequentially excited and read.

In accordance with a first aspect of the present invention, a method of detecting a magnetic feature on an article comprises:

    i) causing relative movement between the feature and a single bias magnetic field generated by a single magnet whose strength monotonically decreases with distance from a maximum and having, along the direction of relative movement, a first region with a relatively strong field strength of a first polarity and a second region with a relatively weak field strength and a second polarity different from the first polarity, whereby the feature is moved successively through the first and second regions, the magnetic feature being magnetized by the biasing field;

    ii) removing the magnetic feature from the influence of the bias magnetic field and detecting the polarity of the magnetized feature to determine if the material has a sufficiently low coercivity that its polarity is influenced by the bias magnetic field in the second region,

wherein the magnetic material of the magnetic feature is sufficiently hard to retain its magnetic polarity between steps i) and ii).

In accordance with a second aspect of the present invention, apparatus for detecting a magnetic feature on an article comprises a bias magnetic field generator in the form of a single magnet for generating a single bias magnetic field whose strength monotonically decreases with distance from a maximum and having a first region with a relatively strong field strength of a first polarity and a second region with a relatively weak field strength of a second polarity different from the first polarity; and an inductive magnetic field detector positioned out of the influence of the bias magnetic field for detecting the polarity of a magnetic feature on an article which has been passed through the first and second regions of the bias magnetic field in succession.

We have realized that the polarity of the magnet field due to a single magnet is reversed in peripheral regions as compared with the polarity at the centre of the magnetic field. We can take advantage of this in the present invention thus allowing the method to be implemented using a single bias magnetic field and generator. The invention has a number of advantages over the prior art. In particular, the use of a single bias magnetic field and a single detector results in a relatively low cost improvement. Conventional banknote handling systems such as sorters, can be readily modified to carry out the new method at low cost. The use of a single detector means that only one signal needs to be analyzed and it is only necessary to detect the initial polarity of the magnetized feature.

In the context of this specification, a "single bias magnetic field" is a magnetic field whose strength monotonically decreases with distance from a maximum. This decrease may be linear or non-linear.

We have also recognized that the invention is particularly applicable to certain new materials which have recently been proposed for use with articles and documents of value. These have particular magnetic properties which allow them to be distinguished from other magnetic materials. In particular, these materials have a lower coercivity than conventional iron oxide materials which means that they can be reversed in polarity by weaker bias magnetic fields, whilst they are still magnetically hard so that they retain the induced magnetism which can then be detected when the article is in a region no longer affected by the bias magnetic field. Typically, these materials can support magnetic data if used in a magnetic tape format.

Suitable magnetic materials for the magnetic feature preferably have a coercivity in the range 50-150 Oe, most preferably 70-100 Oe. The upper limit of 150 Oe could increase with higher biasing fields. A number of examples of suitable materials include iron, nickel, cobalt and alloys of these. In this context, the term "alloy" includes materials such as Nickel:Cobalt, Aluminium: Nickel:Cobalt and the like. Flake nickel materials can be used. In addition, iron flakes are also suitable. Typical iron flakes have lateral dimensions in the range 10-30μm and a thickness less than 2μm.

The preferred materials include metallic iron, nickel and cobalt based materials (and alloys thereof) which have the highest inherent magnetisations and so benefit from the requirement for least material in a product to ensure detectability. Iron is the best of the three with the highest magnetisation, but nickel has been shown to work well from other considerations. We have found that these materials are best used in their flake aspect to ensure that they are high remanence, hard magnetic materials - that can support magnetic data if used in a magnetic tape format. This is because nickel and iron, for example, in flake form generally have a high remanence. Flakes and other shaped materials provide an anisotropy ($K_{shape}$) defined as:

$$K_{shape} = 0.5\ N_d\ M_s^2/\mu_0$$

while

$$H_c \propto 2.K_{total}/M_s$$

leading to a coercivity $H_c$ which is proportional to $M_s$, and $N_d$. (See "Magnetism and Magnetic Materials", J P Jakubovics, Uni Press Cambridge, 2nd Ed.) where:

$N_d$ is the shape factor
$M_s$ is the saturation magnetisation
$\mu_0$ is the permeability of free space
$H_c$ is the coercivity
$K_{total}$ is the sum of all K components

It should be understood, however, that it may not be essential to take account of this shape effect for a material to exhibit low coercivity and high remanence. For example, the crystalline anisotropy of the materials can also lead to high remanence hard magnetic low coercivity even if the material has a spherical shape, for example cobalt treated oxides.

The bias magnetic field may be generated by a permanent magnet or an electromagnet.

An example of a method and apparatus according to the present invention will now be described with reference to the accompanying drawings, in which:-

Figure 1 is a schematic diagram illustrating the principle of the invention;
Figure 2 illustrates the response of a magnetic detector when passed by a conventional magnetic material and a material with a low coercivity;
Figure 3 is a diagram of a banknote sorting machine incorporating an embodiment of the invention; and,
Figure 4 is a flow diagram illustrating the steps in the method.

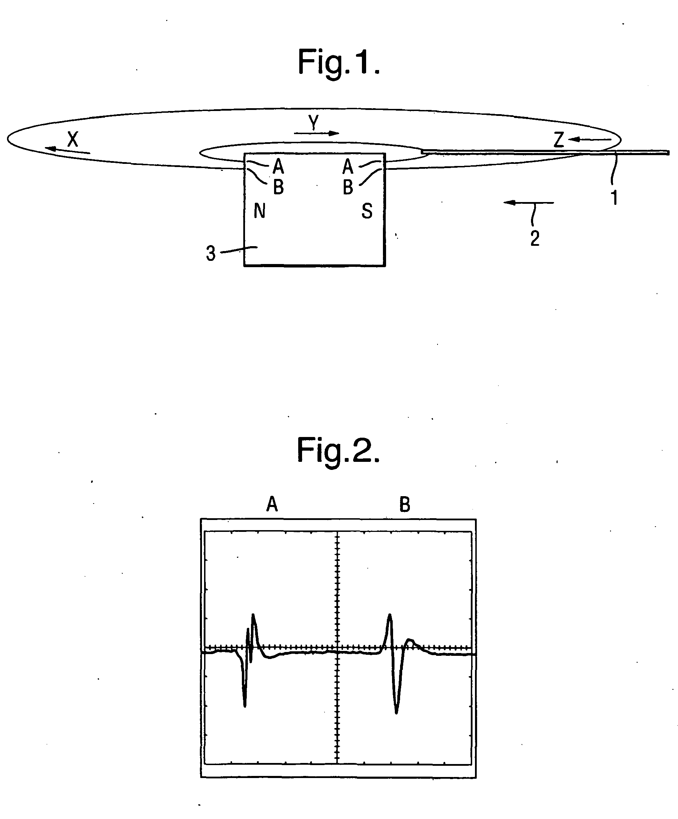

As will be explained below, in use, a banknote 1 (Figure 1) in which is embedded a magnetic security thread or which carries printed ink incorporating a hard magnetic material with a low coercivity is transported in a direction 2 past a permanent magnet 3 arranged with its north (N) and south (S) poles as shown in Figure 1.

At point Z the note 1 is approaching the bias magnet 3 and the magnetic thread (or other magnetic material) starts to be affected magnetically. At point Y the thread is exposed to the maximum bias field in the plane of note travel. If this field is above the thread coercivity then this direction is "recorded" into the hard magnetic material. At point X the H field direction is very nearly reversed compared to its direction at Y but the field strength is much reduced by distance from the magnet. Therefore high coercivity materials are unaffected by this change in polarity and will retain the polarity induced at Y. However, low coercivity materials will be magnetically reversed in polarity.

This reversal in magnetic polarity therefore induces a different polarity of voltage in an inductive sensor by Lenz's law.

This effect can be detected by a detector as explained with reference to Figure 2. Figure 2 is an oscilloscope trace recording the passage of conventional iron oxide thread past an induction head (Section A) followed by a low coercivity thread (Section B). The conventional thread has two tracks of a magnetic pigment spaced apart in the direction of travel. As can be seen from inspecting Figure 2, the initial part of the trace corresponding to the conventional thread is negative going corresponding to a magnetic polarity imparted at point Y in Figure 1. In contrast, the trace in Section B corresponding to a thread made from a low coercivity material (but still a hard magnetic system with high remanence) is initially positive going corresponding to the polarity induced into the thread at position X in Figure 1.

It can thus be seen that it is possible to distinguish between low and high coercivity materials by detecting whether the initial part of the detection signal is positive or negative going. Of course, if the magnet 3 were reversed in polarity then the traces in Sections A and B would be reversed as well and the detector would need to account for this.

We have found by experimentation that as the distance between the thread and the magnet increases, the low coercivity thread no longer shows the different polarity from the high coercivity material. Thus, preferably the permanent magnet 3 is set just a few millimetres from the transport path. This effect is because as the separation between the bias magnet and the note increases, the field strength decreases until it is insufficient to reverse the polarity at position X.

As explained above, any hard magnetic material of sufficiently low coercivity (whilst maintaining a high remanence and so being a hard magnetic material) to be affected by the reversed field geometry described above could be used in a genuine thread or ink for detection. A material coercivity in the range 50-150 Oersted is suitable with a standard bias magnet with a measured field at 1 mm from a pole piece (size approximately 10mm x 10mm x banknote width) of approximately 1.5 kG. Different/ higher strength bias magnets will alter the range of coercivity of materials so affected.

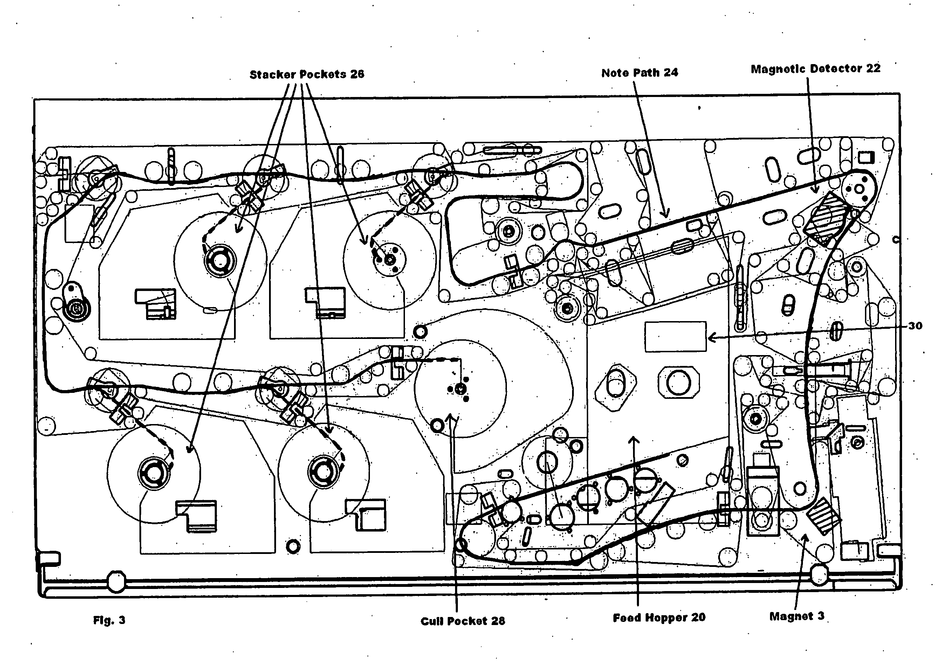

Figure 3 illustrates part of a De La Rue Cobra banknote processing machine in which an embodiment of the present invention is incorporated. The machine includes a feed hopper 20 from which banknotes are fed singly via transport belts past a permanent magnet 3 typically arranged about 1mm from the transport path. As explained above, as magnetic material on the banknote passes the magnet 3, it will be magnetised by the magnet and providing it has a sufficiently hard magnetic property, it will retain that magnetisation as it is transported further to a magnetic detector 22 which is sufficiency far from the magnet 3 to be uninfluenced by its bias magnetic field. Typically, the distance along the transport path between the magnet 3 and the magnetic detector 22 will be in the range 40~50cm while the note feed speed will be between 3.5 and 4.5m per second, typically 3.8m per second. For the magnetic materials mentioned above, these parameters are satisfactory for the material to be detected by the detector 22. It will be appreciated that the magnetic detector 22 must not include an inbuilt bias magnet and thus typically it comprises an inductive head.

After passing the magnetic detector 22, the note is transported further along a note path 24 and is then delivered by suitably actuating a corresponding diverter to one of a number of stacker pockets 26 or, by leaving the diverters unactuated, to a cull pocket 28. In order to process the signals detected by the magnetic detector 22, a control system processor 30 is provided and its function will be described below.

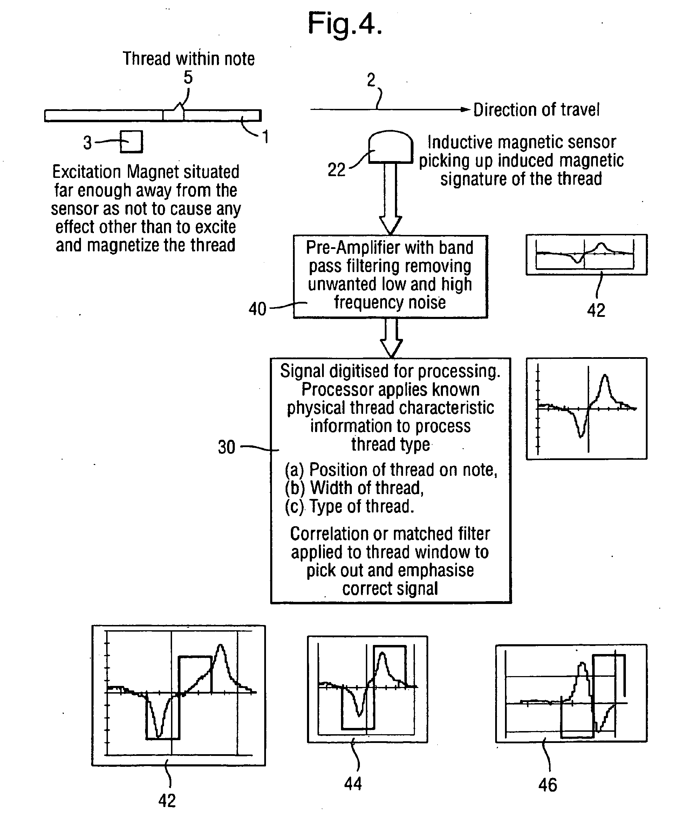

The process for detecting and analysing the security thread is illustrated schematically in Figure 4. Figure 4 illustrates the note 1 with a security thread 5 passing the permanent magnet 3 prior to passing the inductive magnetic sensor head of the detector 22. As the thread 5 passes the head, it will induce a voltage having a magnitude related to the magnitude of the magnetic field and a polarity which corresponds to the polarity of the magnetic field.

This voltage signal is bandpass filtered so as to remove unwanted low and high frequency noise in a suitable preamplifier 40 mounted within the detector 22. The filtered output is shown in Figure 4 at 42. The output is then passed through an A/D converter in the detector 22 and fed to the processor 30. The processor 30 carries out conventional processing on the thread, determining its position on the note and its width, but in addition detects the polarity of the initial part of the voltage trace, i.e. whether it is negative or positive going. In this example, a negative going initial part corresponds to a thread incorporating a low coercivity material and two examples of this are shown at 42 and 44 corresponding to threads with widths of 4mm and 2mm respectively in the direction of the transport. For comparison, the trace 46 illustrates the signal obtained from a conventional high coercivity, iron oxide thread where it will be seen that the initial part of the trace is positive going.

If the processor 30 determines that the thread does not correspond to a genuine thread in that it fails one of the three tests shown in Figure 4 then it will control the transport and diverters so that the note is fed to the cull pocket 28. On the other hand, if the note is found to be genuine then it will be fed to one of the stacker pockets 26 depending upon its denomination.

## Claims

1. A method of detecting a magnetic feature on an article, the method comprising:

   i) causing relative movement between the feature and a single bias magnetic field generated by a single magnet whose strength monotonically decreases with distance from a maximum and having, along the direction of relative movement, a first region with a relatively strong field strength of a first polarity and a second region with a relatively weak field strength and a second polarity different from the first polarity, whereby the feature is moved successively through the first and second regions, the magnetic feature being magnetized by the biasing field;
   ii) removing the magnetic feature from the influence of the bias magnetic field and detecting the polarity of the magnetized feature to determine if the material has a sufficiently low coercivity that its polarity is influenced by the bias magnetic field in the second region,

   wherein the magnetic material of the magnetic feature is sufficiently hard to retain its magnetic polarity between steps i) and ii).

2. A method according to claim 1, wherein the article is transported by a transport system through the bias magnetic field to the position at which the polarity of the feature is detected.

3. A method according to claim 1 or claim 2, wherein the magnetic feature has an elongate form.

4. A method according to any of the preceding claims, wherein the magnetic feature is printed on the article.

5. A method according to any of claims 1 to 3, wherein the magnetic feature is embedded in the article.

6. A method according to claim 5, wherein the magnetic feature comprises a security thread.

7. A method according to any of the preceding claims, wherein the magnetic material of the magnetic feature has a coercivity in the range 50-150 Oe.

8. A method according to claim 7, wherein the magnetic material of the magnetic feature has a coercivity in the range 70-100 Oe.

9. A method according to any of the preceding claims, wherein the material of the magnetic feature comprises one or iron, nickel, cobalt and their alloys, preferably in flake form.

10. A method according to any of the preceding claims, wherein the bias magnetic field is generated by an electromagnet.

11. A method according to any of claims 1 to 9, wherein the bias magnetic field is generated by a permanent magnet.

12. A method according to any of the preceding claims, wherein the article comprises a document.

13. A method according to claim 12, wherein the document comprises a banknote or other article of value.

14. A method according to any of the preceding claims, wherein the second polarity is in the opposite direction to the first polarity.

15. A method according to at least claim 2, wherein if it is determined that the polarity of the feature corresponds to that of the second region, indicating that the magnetic material of the magnetic feature has a sufficiently low coercivity that its polarity is influenced by the bias magnetic field in the second region, the method further comprises handling the article in a predetermined manner responsive to the said determination.

16. A method according to claim 15, wherein the predetermined manner comprises routing an article which does not carry a magnetic feature with a sufficiently low coercivity to a cull output location.

17. Apparatus for detecting a magnetic feature on an article, the apparatus comprising a bias magnetic field generator in the form of a single magnet for generating a single bias magnetic field whose strength monotonically decreases with distance from a maximum and having a first region with a relatively strong field strength of a first polarity and a second region with a relatively weak field strength of a second polarity different from the first polarity; and an inductive magnetic field detector positioned out of the influence of the bias magnetic field for detecting the polarity of a magnetic feature on an article which has been passed through the first and second regions of the bias magnetic field in succession.

18. Apparatus according to claim 17, further comprising a transport system for moving an article through the bias magnetic field such that the article first passes through the first region and then through the second region, and then for moving the article to the detector.

19. Apparatus according to claim 17 or claim 18, wherein the bias magnetic field generator comprises a permanent magnet.

20. An article sorting system comprising apparatus according to at least claim 18; and a control system, responsive to the output of the detector, to determine from the detector output whether the polarity of the feature corresponds to that of the second region, indicating that the magnetic material of the magnetic feature has a sufficiently low coercivity that its polarity is influenced by the bias magnetic field in the second region, and to handle the article in a predetermined manner responsive to the said determination.

21. A system according to claim 20, further comprising at least two output locations, one of which is a cull output location, the control system being adapted to route an article which does not carry a magnetic feature with a sufficiently low coercivity to the cull output location.

**Patentansprüche**

1. Verfahren zur Erkennung eines magnetischen Merkmals an einem Gegenstand, wobei das Verfahren Folgendes umfasst:

    i) Bewirken einer relativen Bewegung zwischen dem Merkmal und einem einzelnen Vormagnetisierungsfeld, das durch einen einzelnen Magneten erzeugt wird, dessen Stärke mit dem Abstand zu einem Maximum monoton abnimmt, und das in Richtung der relativen Bewegung einen ersten Bereich mit einer relativ hohen Feldstärke einer ersten Polarität und einen zweiten Bereich mit einer relativ geringen Feldstärke und einer zweiten Polarität, die sich von der ersten Polarität unterscheidet, aufweist, wobei das Merkmal nacheinander durch den ersten und den zweiten Bereich bewegt wird, wobei das magnetische Merkmal durch das Vormagnetisierungsfeld magnetisiert wird,

ii) Entfernen des magnetischen Merkmals aus dem Einfluss des Vormagnetisierungsfeldes und Erkennen der Polarität des magnetisierten Merkmals, um zu bestimmen, ob das Material eine ausreichend geringe Koerzivität aufweist, damit seine Polarität durch das Vormagnetisierungsfeld im zweiten Bereich beeinflusst wird,

wobei das magnetische Material des magnetischen Merkmals ausreichend hart ist, um seine magnetische Polarität zwischen den Schritten i) und ii) zu erhalten.

2. Verfahren nach Anspruch 1, wobei der Gegenstand von einem Transportsystem durch das Vormagnetisierungsfeld zu der Position transportiert wird, an der die Polarität des Merkmals erkannt wird.

3. Verfahren nach Anspruch 1 oder Anspruch 2, wobei das magnetische Merkmal eine längliche Form aufweist.

4. Verfahren nach einem der vorhergehenden Ansprüche, wobei das magnetische Merkmal auf den Gegenstand gedruckt ist.

5. Verfahren nach einem der Ansprüche 1 bis 3, wobei das magnetische Merkmal in den Gegenstand eingebettet ist.

6. Verfahren nach Anspruch 5, wobei das magnetische Merkmal einen Sicherheitsfaden umfasst.

7. Verfahren nach einem der vorhergehenden Ansprüche, wobei das magnetische Material des magnetischen Merkmals eine Koerzivität im Bereich von 50 bis 150 Oe aufweist.

8. Verfahren nach Anspruch 7, wobei das magnetische Material des magnetischen Merkmals eine Koerzivität im Bereich von 70 bis 100 Oe aufweist.

9. Verfahren nach einem der vorhergehenden Ansprüche, wobei das Material des magnetischen Merkmals eines der Folgenden umfasst: Eisen, Nickel, Kobalt, und deren Legierungen, vorzugsweise in Flockenform.

10. Verfahren nach einem der vorhergehenden Ansprüche, wobei das Vormagnetisierungsfeld durch einen Elektromagneten erzeugt wird.

11. Verfahren nach einem der Ansprüche 1 bis 9, wobei das Vormagnetisierungsfeld durch einen Permanentmagneten erzeugt wird.

12. Verfahren nach einem der vorhergehenden Ansprüche, wobei der Gegenstand ein Dokument umfasst.

13. Verfahren nach Anspruch 12, wobei das Dokument eine Banknote oder einen anderen Wertgegenstand umfasst.

14. Verfahren nach einem der vorhergehenden Ansprüche, wobei die zweite Polarität der ersten Polarität entgegengesetzt ist.

15. Verfahren nach mindestens Anspruch 2, wobei das Verfahren ferner das Handhaben des Gegenstandes in einer vorher festgelegten Weise in Reaktion auf die Bestimmung umfasst, wenn bestimmt wird, dass die Polarität des Merkmals der des zweiten Bereiches entspricht, was anzeigt, dass das magnetische Material des magnetischen Merkmals eine ausreichend geringe Koerzivität aufweist, damit seine Polarität durch das Vormagnetisierungsfeld im zweiten Bereich beeinflusst wird.

16. Verfahren nach Anspruch 15, wobei die vorher festgelegte Weise das Leiten eines Gegenstandes, der kein magnetisches Merkmal mit ausreichend geringer Koerzivität trägt, zu einer Ausschuss-Ausgabestelle umfasst.

17. Vorrichtung zum Erkennen eines magnetischen Merkmals auf einem Gegenstand, wobei die Vorrichtung einen Vormagnetisierungsfeld-Generator in Form eines einzelnen Magneten umfasst, um ein einzelnes Vormagnetisierungsfeld zu erzeugen, dessen Stärke mit dem Abstand zu einem Maximum monoton abnimmt, und das einen ersten Bereich mit einer relativ hohen Feldstärke einer ersten Polarität und einen zweiten Bereich mit einer relativ geringen Feldstärke einer zweiten Polarität, die sich von der ersten Polarität unterscheidet, aufweist, sowie einen Detektor für ein induktives Magnetfeld, der außerhalb des Einflusses des Vormagnetisierungsfeldes angeordnet ist, um die Polarität eines magnetischen Merkmals auf einem Gegenstand zu erkennen, der nacheinander den ersten und den zweiten Bereich des Vormagnetisierungsfeldes durchlaufen hat.

18. Vorrichtung nach Anspruch 17, ferner ein Transportsystem zum Bewegen eines Gegenstandes durch das Vormagnetisierungsfeld, so dass der Gegenstand zuerst den ersten Bereich und dann den zweiten Bereich durchläuft, und zum nachfolgenden Bewegen des Gegenstandes zum Detektor umfassend.

**19.** Vorrichtung nach Anspruch 17 oder Anspruch 18, wobei der Vormagnetisierungsfeld-Erzeuger einen Permanentmagneten umfasst.

**20.** Gegenständesortierungssystem, eine Vorrichtung nach mindestens Anspruch 18 und ein auf die Ausgabe des Detektors reagierendes Steuersystem umfassend, um aus der Detektorausgabe zu bestimmen, ob die Polarität des Merkmals der des zweiten Bereiches entspricht, was anzeigt, dass das magnetische Material des magnetischen Merkmals eine ausreichend geringe Koerzivität aufweist, damit seine Polarität durch das Vormagnetisierungsfeld im zweiten Bereich beeinflusst wird, und um den Gegenstand in einer vorher festgelegten Weise in Reaktion auf die Bestimmung zu handhaben.

**21.** System nach Anspruch 20, ferner mindestens zwei Ausgabestellen umfassend, von denen eine eine Ausschuss-Ausgabestelle ist, wobei das Steuersystem dafür eingerichtet ist, einen Gegenstand, der kein Merkmal mit einer ausreichend geringen Koerzivität trägt, zur Ausschuss-Ausgabestelle zu leiten.

## Revendications

**1.** Procédé de détection d'une particularité magnétique sur un article, le procédé comprenant les étapes consistant à :

i) provoquer un mouvement relatif entre la particularité et un champ magnétique de polarisation unique généré par un aimant unique dont l'intensité diminue de façon monotone avec la distance à partir d'un maximum et ayant, le long de la direction du mouvement relatif, une première région avec une intensité de champ relativement forte d'une première polarité et une seconde région avec une intensité de champ relativement faible et une seconde polarité différente de la première polarité, moyennant quoi la particularité est déplacée successivement à travers les première et seconde régions, la particularité magnétique étant magnétisée par le champ de polarisation ;
ii) retirer la particularité magnétique de l'influence du champ magnétique de polarisation et détecter la polarité de la particularité magnétisée pour déterminer si le matériau a une coercivité suffisamment basse pour que sa polarité soit influencée par le champ magnétique de polarisation dans la seconde région,

dans lequel le matériau magnétique de la particularité magnétique est suffisamment dur pour retenir sa polarité magnétique entre les étapes i) et ii).

**2.** Procédé selon la revendication 1, dans lequel l'article est transporté par un système de transport à travers le champ magnétique de polarisation vers la position à laquelle la polarité de la particularité est détectée.

**3.** Procédé selon la revendication 1 ou la revendication 2, dans lequel la particularité magnétique a une forme allongée.

**4.** Procédé selon l'une quelconque des revendications précédentes, dans lequel la particularité magnétique est imprimée sur l'article.

**5.** Procédé selon l'une quelconque des revendications 1 à 3, dans lequel la particularité magnétique est intégrée dans l'article.

**6.** Procédé selon la revendication 5, dans lequel la particularité magnétique comprend un fil de sécurité.

**7.** Procédé selon l'une quelconque des revendications précédentes, dans lequel le matériau magnétique de la particularité magnétique a une coercivité dans la plage de 50 à 150 Oe.

**8.** Procédé selon la revendication 7, dans lequel le matériau magnétique de la particularité magnétique a une coercivité dans la plage de 70 à 100 Oe.

**9.** Procédé selon l'une quelconque des revendications précédentes, dans lequel le matériau de la particularité magnétique comprend un élément parmi le fer, le nickel, le cobalt et leurs alliages, de préférence sous la forme de flocons.

**10.** Procédé selon l'une quelconque des revendications précédentes, dans lequel le champ magnétique de polarisation est généré par un électro-aimant.

**11.** Procédé selon l'une quelconque des revendications 1 à 9, dans lequel le champ magnétique de polarisation est généré par un aimant permanent.

**12.** Procédé selon l'une quelconque des revendications précédentes, dans lequel l'article comprend un document.

**13.** Procédé selon la revendication 12, dans lequel le document comprend un billet de banque ou un autre article de valeur.

**14.** Procédé selon l'une quelconque des revendications précédentes, dans lequel la seconde polarité est dans la direction opposée à la première polarité.

15. Procédé selon au moins la revendication 2, dans lequel si l'on détermine que la polarité de la particularité correspond à celle de la seconde région, ce qui indique que le matériau magnétique de la particularité magnétique a une coercivité suffisamment basse pour que sa polarité soit influencée par le champ magnétique de polarisation dans la seconde région, le procédé comprend en outre la manipulation de l'article d'une façon prédéterminée en réponse à ladite détermination.

16. Procédé selon la revendication 15, dans lequel la façon prédéterminée comprend le routage d'un article qui ne porte pas de particularité magnétique avec une coercivité suffisamment basse vers un emplacement de sortie de tri.

17. Appareil de détection d'une particularité magnétique sur un article, l'appareil comprenant un générateur de champ magnétique de polarisation sous la forme d'un aimant unique pour générer un champ magnétique de polarisation unique dont l'intensité diminue de façon monotone avec la distance à partir d'un maximum et ayant une première région avec une intensité de champ relativement forte d'une première polarité et une seconde région avec une intensité de champ relativement faible d'une seconde polarité différente de la première polarité ; et un détecteur de champ magnétique inductif positionné hors de l'influence du champ magnétique de polarisation afin de détecter la polarité d'une particularité magnétique sur un article que l'on a passé successivement à travers les première et seconde régions du champ magnétique de polarisation.

18. Appareil selon la revendication 17, comprenant en outre un système de transport permettant de déplacer un article à travers le champ magnétique de polarisation de telle sorte que l'article passe d'abord à travers la première région puis à travers la seconde région, puis permettant de déplacer l'article vers le détecteur.

19. Appareil selon la revendication 17 ou la revendication 18, dans lequel le générateur de champ magnétique de polarisation comprend un aimant permanent.

20. Système de tri d'articles comprenant un appareil selon au moins la revendication 18 ; et un système de commande, réceptif à la sortie du détecteur, pour déterminer à partir de la sortie de détecteur si la polarité de la particularité correspond à celle de la seconde région, indiquant que le matériau magnétique de la particularité magnétique a une coercivité suffisamment basse pour que sa polarité soit influencée par le champ magnétique de polarisation dans la seconde région, et pour manipuler l'article d'une façon prédéterminée en réponse à ladite détermination.

21. Système selon la revendication 20, comprenant en outre au moins deux emplacements de sortie, dont l'un est un emplacement de sortie de tri, le système de commande étant adapté pour router un article qui ne porte pas de particularité magnétique avec une coercivité suffisamment basse vers l'emplacement de sortie de tri.

# Fig.1.

# Fig.2.

EP 1 770 657 B1

Fig. 3

10

# Fig.4.

Thread within note
5

3 —

Excitation Magnet situated
far enough away from the
sensor as not to cause any
effect other than to excite
and magnetize the thread

1

2

→ Direction of travel

22

Inductive magnetic sensor
picking up induced magnetic
signature of the thread

Pre-Amplifier with band
pass filtering removing
unwanted low and high
frequency noise

40

42

Signal digitised for processing.
Processor applies known
physical thread characteristic
information to process
thread type

30

(a) Position of thread on note,
(b) Width of thread,
(c) Type of thread.

Correlation or matched filter
applied to thread window to
pick out and emphasise
correct signal

42

44

46

## REFERENCES CITED IN THE DESCRIPTION

### Patent documents cited in the description

- US 4584529 A
- US 4749087 A
- US 6707295 A
- GB 1534859 A
- GB 2130414 A
- EP 640841 A

### Non-patent literature cited in the description

- **J P JAKUBOVICS.** Magnetism and Magnetic Materials. Uni Press Cambridge